# EUROPÄISCHE PATENTSCHRIFT

(11) **EP 0 571 411 B1**
(45) Veröffentlichungstag und Bekanntmachung des Hinweises auf die Patenterteilung: **12.10.1994**
(21) Anmeldenummer: 92903583.0
(22) Anmeldetag: 04.02.1992
(51) Int. Cl.: G11B 20/10, H03M 5/18, H03K 5/08

(54) **SCHALTUNG ZUM ERZEUGEN EINES BINÄRSIGNALS AUS EINEM TERNÄREN SIGNAL**
CIRCUITRY FOR GENERATING BINARY SIGNALS FROM TERNARY SIGNALS
CIRCUIT GENERATEUR DE SIGNAUX BINAIRES A PARTIR DE SIGNAUX TERNAIRES

(30) Priorität: 15.02.1991 DE 4104645
(43) Veröffentlichungstag der Anmeldung: 01.12.1993
(73) Patentinhaber: DEUTSCHE THOMSON-BRANDT GMBH, 78048 Villingen-Schwenningen (DE)
(72) Erfinder: SCHOLZ, Werner, D-3007 Gehrden (DE)
(74) Vertreter: Einsel, Robert, Dipl.-Ing.
(86) Internationale Anmeldenummer: EP9200233
(87) Internationale Veröffentlichungsnummer: WO9215094

(56) Entgegenhaltungen:
- EP-A- 0 084 358
- DE-A- 3 225 946
- GB-A- 2 217 957
- Patent abstracts of Japan, vol. 12, no. 245, p729, abstract of JP63-37867, publ. 1988-02-18 TOYO ELECTRON KK
- IBM Technical Disclosure Bulletin, vol.15, no. 12, May 1973 H.H. Ottesen et al.:"ADAPTIVE DC RESTORATION", see page 3779-3780

## Beschreibung

Die Erfindung geht aus von einer Schaltung gemäß dem Oberbegriff des Anspruchs 1.

Bei der Wiedergabe magnetisch aufgezeichneter Digitalsignale wird vom Band ein ternäres Signal mit drei Zuständen abgetastet. Aus diesem Signal soll ein binäres Signal mit nur zwei Zuständen erzeugt werden. Für die Auswertung sind Pegelentscheider notwendig, um den Low- und High-Pegel des Signals zu detektieren. Bei bekannten Schaltungen wird als Pegelentscheider im allgemeinen ein Schmitt-Trigger verwendet. Derartigen Schaltungen benötigen eine automatische Verstärkungsregelung (AGC = automatic gain control), um die optimalen Triggerpunkte einzuhalten. Außerdem erfolgt die automatische Symmetrierung der Triggerpunkte in bekannten Schaltungen nur dann, wenn das binäre Signal gleichspannungsfrei ist.

Es ist ferner bekannt aus EP-A 0 084 354, zum Bewerten von Lesesignalen eines Magnetschichtspeichers einen abgegebenen Leseimpuls zu verstärken und zu differenzieren, so daß bei Nulldurchgängen Datenimpulse erzeugt werden.

Der Erfindung liegt die Aufgabe zugrunde, eine Schaltung zur Pegelentscheidung zu schaffen, bei der die Einhaltung der optimalen Triggerpunkte am ternären Signal weder eine automatische Verstärkungsregelung (AGC) noch die Gleichspannungsfreiheit des Binärsignals erfordert.

Diese Aufgabe wird erfindungsgemäß dadurch gelöst, daß jeweils gleich gepolte Eingänge (+ bzw. -) der Komparatoren (2, 3) an unterschiedliche Vorspannungen (Uo, U1) angeschlossen sind, daß die Differenz zwischen den beiden Vorspannungen durch den Mittelwert der Ausgangsspannungen (C1, C2) der Komparatoren so geregelt ist, daß die mittlere Impulsbreite der Ausgangsspannungen etwa konstant ist.

Zur Bildung des Binärsignals werden die Ausgangsimpulse der beiden Komparatoren vorzugsweise den beiden Eingängen eines R-S-Flip-Flop zugeführt. Zur Regelspannungserzeugung werden die Ausgangsimpulse der beiden Komparatoren mit einem Gatter zusammengefaßt. Vorzugsweise wird der Mittelwert der Ausgangsspannung des Gatters über einen Verstärker gleichen Eingängen der beiden Komparatoren als Vorspannung zugeführt.

Die Ausgangsimpulse des Gatters können einer Schaltung zur Regenerierung des Bittaktes zugeführt werden. Durch eine Einstellmöglichkeit für die Vorspannungsdifferenz kann die Impulsbreite verändert werden. Die Einstellung der Vorspannungsdifferenz und damit die Schwellwertlage erfolgt zweckmäßigerweise so, daß sich eine möglichst geringe Bitfehlerrate ergibt.

Die bekannte Schaltung und ein Ausführungsbeispiel der erfindungsgemäßen Schaltung werden im folgenden anhand der Zeichnung erläutert. Darin zeigen
- Fig. 1: ein Übersichtsschaltbild zur Wiedergewinnung aufgezeichneter Digitalsignale,
- Fig. 2: Kurven zur Erläuterung der Schaltung nach Fig. 1,
- Fig. 3: eine bekannte Schaltung zur Pegelentscheidung,
- Fig. 4: Kurven zur Erläuterung der Schaltung nach Fig. 3,
- Fig. 5: eine erfindungsgemäß ausgebildete Schaltung und
- Fig. 6: Kurven zur Erläuterung der Schaltung nach Fig. 5.

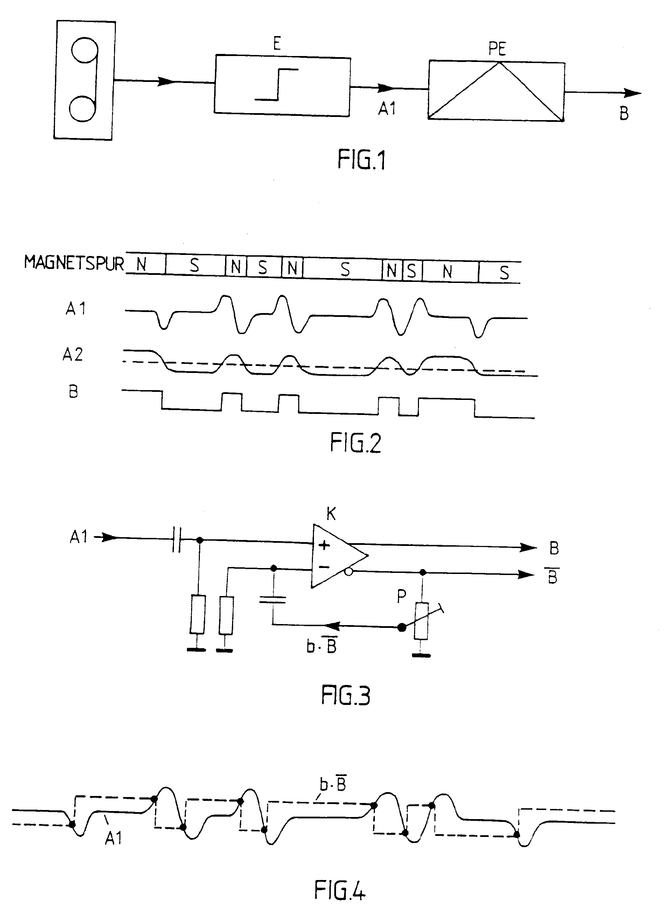

Fig. 1 zeigt eine Anordnung zur Erzeugung eines Binärsignals aus einem Signal, das durch Abtastung einer binären Aufzeichnungspur gewonnen ist.

Fig. 2 zeigt die zugehörigen Signalverläufe. Die Magnetspur enthält das Bitmuster in binärer Form, d.h. in Form entgegengesetzt magnetisierter Bereiche N (Nordpol) und S (Südpol). Im Wiedergabekopf wird durch die Flußänderung zwischen den Bereichen N und S-die Wiedergabespannung induziert. Diese Spannung stellt etwa das differenzierte Bitmuster dar. Die durch die Nagnetisierungsänderungen zwischen dem Nordpol N und dem Südpol S erzeugten Impulse werden in der Entzerrungsschaltung E verschmälert und möglichst weitgehend von den Einflüssen der Nachbarimpulse befreit. Das Ergebnis ist durch das Signal A1 dargestellt. Durch Integration des Signals A1 wird das Signal A2 gewonnen. Um aus A2 das binäre Signal B zu erzeugen, wird als Pegelentscheider PE ein einfacher Nulldurchgangsdetektor verwendet, der weitgehend pegelunabhängig ist. Sofern das binäre Signal B tieffrequente Spektralanteile und große Runlength-Werte enthält, ist es günstiger, das ternäre Signal A1 direkt mit dem Pegelentscheider auszuwerten. Hierzu kann z.B. ein Schmitt-Trigger verwendet werden, der abwechselnd die positiven und negativen Impulse erfaßt.

Fig. 3 zeigt eine Schmitt-Triggerschaltung, und
Fig. 4 die Arbeitsweise dieser Schaltung. Die Schaltung enthält einen Komparator K mit binärem Ausgang. Durch Rückführung des Ausgangssignals auf einen der Eingänge wird eine Hysterese des Triggerpunktes erzeugt und damit der Schwellwert abwechselnd in den Pegelbereich der positiven und negativen Impulse gelegt. Mit Hilfe des Potentiometers P können die Triggerpunkte so eingestellt werden, daß sich eine möglichst geringe Bitfehlerrate ergibt. Der Nachteil dieser Schaltung gegenüber dem Nulldurchgangsdetektor besteht in der Pegelabhängigkeit. Um die optimalen Triggerpunkte einzuhalten, ist eine automatische Verstärkungsregelung für das ternäre Signal A1 erforderlich. Außerdem erfolgt die automatische Symmetrierung der Triggerpunkte in der Schaltung nach Fig. 3 nur dann, wenn das binäre Signal B gleichspannungsfrei ist. Das ternäre Signal A1 ist dagegen von Natur aus gleichspannungsfrei.

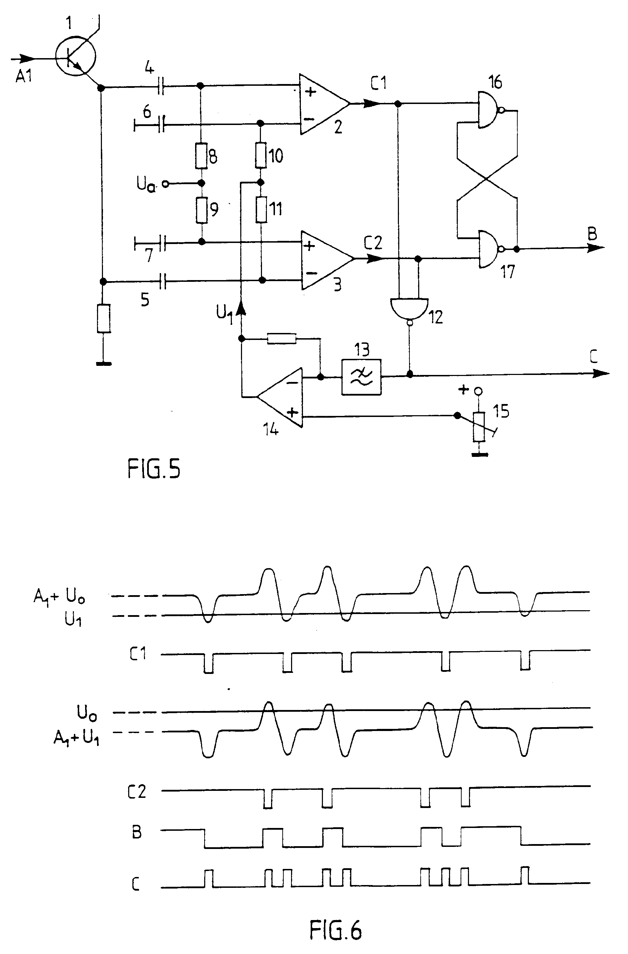

In Fig. 5 wird das Signal A1 der Schaltung über den Emitterfolger 1 zugeführt. Die Schaltung enthält zwei Komparatoren mit 2, 3 mit binärem Ausgang. Die direkten Eingänge (+) der beiden Komparatoren 2, 3 erhalten die Vorspannung Uo über die Widerstände 8, 9. Die invertierenden (-) Eingänge erhalten die geregelte Vorspannung U1 über die Widerstände 10,11.

Das Signal A1 wird dem direkten Eingang des Komparators 2 über den Kondensator 4 und dem invertierenden Eingang des Komparators 3 über den Kondensator 5 zugeführt. Die anderen beiden Eingänge der Komparatoren 2, 3 sind über die Kondensatoren 6 und 7 wechselstrommäßig an Masse gelegt. Wie Fig. 6 zeigt, erzeugen die negativen Impulse von A1 am Ausgang des Komparators 2 die Impulsspannung C1 und die positiven Impulse von A1 die Impulsspannung C2 am Ausgang des Komparators 2. Mit dem Gatter 12 werden die Impulse C1 und C2 zur Impulsspannung C zusammengefaßt. Der Mittelwert der Spannung C ist ein Maß für die Lage des Schwellwertes an den Eingängen der Komparatoren 2, 3. Da die Impulse der ternären Signals A1 eine verhältnismäßig geringe Flankensteilheit aufweisen, werden die Impulse der Spannung C um so breiter, je dichter der Schwellwert an der Mittellinie des Signals A1 liegt. Über den Tiefpaß 13 wird der Mittelwert der Spannung C dem Verstärker 14 zugeführt, der die Vorspannung U1 liefert. Wenn die Impulse C breiter werden, sinkt die Spannung U1. Dadurch wird der Schwellwert so verschoben, daß die Impulse C wieder schmaler werden. Die Regelung bewirkt also die Einhaltung einer bestimmten mittleren Impulsbreite der Impulse C. Die Einhaltung der Impulsbreite von C ist um so genauer, je größer die Verstärkung des Verstärkers 14 ist. Die Einhaltung der Impulsbreite von C entspricht der Einhaltung eines bestimmten Schwellwertes relativ zur Impulshöhe, ist also unabhängig von der Impulsamplitude. Die Einstellung des optimalen Schwellwertes, bei dem sich z.B. die minimale Bitfehlerrate ergibt, erfolgt mit dem Potentiometer 15. Die Lage des Schwellwertes ist hier allerdings auch von der Häufigkeit der Pegelübergänge im Binärsignal abhängig. Diese ist jedoch bei einem festgelegten Aufzeichnungssignal mit Mittel konstant. Die Zeitkonstante der Regelschleife wird so gewählt, daß sich ein genügend konstanter Mittelwert einstellt.

Das ursprüngliche Binärsignal, das dem Magnetisierungsmuster der Aufzeichnungspur bzw. dem Aufzeichnungsstrom entspricht, wird in der Schaltung nach Fig. 5 dadurch gewonnen, daß die Impulsspannungen C1 und C2 dem aus den Gattern 16 und 17 gebildeten R-S-Flip-Flop zugeführt werden. Am Ausgang des Flip-Flop entsteht also, wie Fig. 6 zeigt, das Signal B. Mit Hilfe dieses Signals kann in einer PLL-Schaltung der Bittakt regeneriert und das Signal B durch Abtastung mit dem Bittakt für die Weiterverarbeitung aufbereitet werden. Für die Regenerierung des Bittaktes ist auch das Signal C geeignet, das je Pegelübergang des Signals B einen Impuls enthält.

Es ist auch möglich, daß die beschriebene Schaltung nur das Signal für die Regenerierung des Bittaktes erzeugt. Dabei wird dann der Bittakt verwendet, um das ternäre Signal A1 mit Hilfe eines A/D-Wandlers abzutasten. Durch eine spezielle Verarbeitung der Abtastwerte kann dann das Binärsignal mit erhöhter Störsicherheit wiedergewonnen werden.

## Patentansprüche

1. Schaltung zum Erzeugen eines Binärsignals (B, C) aus einem ternären Signal, das durch Übertragung eines Binärsignals über einen Hochpaß- oder Tiefpaß-Kanal entstanden ist, insbesondere bei der Abtastung eines Aufzeichnungsträgers mit binärer Aufzeichnung, und Impulse enthält, die bezüglich einer Mittellinie abwechselnd positiv und negativ gerichtet sind, wobei das Signal (A1) an entgegengesetzt gepolte Eingänge (+, -) von zwei Komparatoren (2, 3) angelegt ist, **dadurch gekennzeichnet,** daß jeweils gleich gepolte Eingänge ( + bzw. -) der Komparatoren (2, 3) an unterschiedliche Vorspannungen (Uo, U1) angeschlossen sind, daß die Differenz zwischen den beiden Vorspannungen durch den Mittelwert der Ausgangsspannungen (C1, C2) der Komparatoren so geregelt ist, daß die mittlere Impulsbreite der Ausgangsspannungen etwa konstant ist.

2. Schaltung nach Anspruch 3, **dadurch gekennzeichnet,** daß die Ausgangsimpulse der beiden Komparatoren (2, 3) zur Bildung des Binärsignals (B) an die Eingängen eines R-S-Flip-Flop (16, 17) angelegt sind.

3. Schaltung nach Anspruch 1, **dadurch gekennzeichnet,** daß die Ausgangsimpulse der beiden Komparatoren (2, 3) mit einem Gatter (12) zusammengefaßt sind.

4. Schaltung nach Anspruch 3, **dadurch gekennzeichnet,** daß der Mittelwert der Ausgangsspannung des Gatters (12) an einen Verstärker und die Ausgangsspannung (U1) des Verstärkers (14) an gleiche Eingänge der beiden Komparatoren (2, 3) als Vorspannung angelegt ist.

5. Schaltung nach Anspruch 3, **dadurch gekennzeichnet,** daß die Ausgangsimpulse des Gatters (12) an eine Schaltung zur Regenerierung des Bittaktes angelegt sind.

6. Schaltung nach Anspruch 1, **dadurch gekennzeichnet,** daß eine Einstellmöglichkeit (15) für die Impulsbreite vorgesehen ist, und daß die Einstellung auf eine möglichst geringe Bitfehlerrate erfolgt.

## Claims

1. Circuit for generating a binary signal (B, C) from a ternary signal which has resulted from transmission of a binary signal over a high pass or low pass channel, in particular during the scanning of a recording medium having a binary recording, and which contains pulses that are directed alternately positive and negative with respect to a centre line, wherein the signal (A1) is applied to oppositely poled inputs (+, -) of two comparators (2, 3), characterised in that, respective like poled inputs (+ or -) of the comparators (2, 3) are connected to different bias voltages (Uo, U1), that the difference between the two bias voltages is regulated by the average value of the output voltages (C1, C2) of the comparators such that the average pulse width of the output voltages is approximately constant.

2. Circuit in accordance with Claim 1, characterised in that, the output pulses of the two comparators (2, 3) are applied to the inputs of an R-S flip-flop (16, 17) for forming the binary signal (B).

3. Circuit in accordance with Claim 1, characterised in that, the output pulses of the two comparators (2, 3) are combined in a gate (12).

4. Circuit in accordance with Claim 3, characterised in that, the average value of the output voltage of the gate (12) is applied to an amplifier and the output voltage (U1) of the amplifier (14) is applied to like inputs of the two comparators (2, 3) as a bias voltage.

5. Circuit in accordance with Claim 3, characterised in that, the output pulses of the gate (12) are applied to a circuit for regenerating the bit rate.

6. Circuit in accordance with Claim 1, characterised in that, a means (15) is provided for adjusting the pulse width and that the adjustment is effected for a smallest possible bit error rate.

## Revendications

1. Circuit destiné à la génération d'un signal binaire (B, C) à partir d'un signal ternaire obtenu par la transmission d'un signal binaire par le biais d'une voie à filtre passe-haut ou passe-bas, notamment lors de l'échantillonnage d'un support d'enregistrement avec enregistrement binaire et contenant des impulsions qui, par rapport à une ligne médiane, sont orientées alternativement du côté positif et du côté négatif, le signal (A1) étant appliqué sur des entrées à pôles opposés (+, -) de deux comparateurs (2, 3), caractérisé en ce que les entrées à pôles identiques (+ ou -) des comparateurs (2, 3) sont raccordées respectivement à des polarisations distinctes (U0, U1), que la différence entre les deux polarisations est réglée, par la valeur moyenne des tensions de sortie (C1, C2) des comparateurs de manière à ce que la largeur d'impulsion moyenne des tensions de sortie soit plus ou moins constante.

2. Circuit selon revendication 1, caractérisé en ce que les impulsions de sortie des deux comparateurs (2, 3) sont appliquées aux entrées d'un flip-flop RS (16, 17) pour la formation du signal binaire (B).

3. Circuit selon revendication 1, caractérisé en ce que les impulsions de sortie des deux comparateurs (2, 3) sont réunies par une porte logique (12).

4. Circuit selon revendication 3, caractérisé en ce que la valeur moyenne de la tension de sortie de la porte logique (12) est appliquée à un amplificateur et que la tension de sortie (U1) de l'amplificateur (14) est appliquée à des entrées identiques des deux comparateurs (2, 3) comme tension de polarisation.

5. Circuit selon revendication 3, caractérisé en ce que les impulsions de sortie de la porte logique (12) sont appliquées à un circuit de régénération du rythme de bits.

6. Circuit selon revendication 1, caractérisé en ce qu'il est prévu une possibilité de réglage (15) pour la largeur d'impulsion et que ce réglage est tel qu'il en résulte le plus bas taux d'erreur possible sur les bits.
